# EUROPEAN PATENT APPLICATION

(11) **EP 3 833 175 A1**
(43) Date of publication of application: **09.06.2021**
(21) Application number: 19214182.8
(22) Date of filing: 06.12.2019
(51) Int. Cl.: H05K 13/04

(54) **A MOUNTING TOOL FOR A COMPONENT MOUNTING MACHINE**

(71) Applicant: Mycronic AB, 183 03 Täby (SE)
(72) Inventor: Axelsson, Robert, 125 74 Älvsjö (SE)
(74) Representative: AWA Sweden AB

(57) **Abstract**

The present invention provides a mounting tool (20) for picking and placing a component in a component mounting machine (60). The mounting tool (20) comprises a base portion (21) arranged at an upper end of said mounting tool, a tip holder (22) extending from said base portion (21) in the vertical direction and further supported in said base portion (21) by at least one plain bearing (24) around a vertical rotational axis (V); a mounting tool tip (1) attached to said tip holder (22) at a lower end of said mounting tool (20) and arranged for engagement with a component to be mounted. The tip holder (22) is spring loaded in said base portion (21) with a coiled spring (25) extending around the vertical rotational axis (V) and attached to said tip holder (22) such that said tip holder (22) may be pressed down in the vertical direction against the elastic force of said coiled spring (25) upon engagement with a component to be mounted. Furthermore, the tip holder (22) is arranged with a preloading force against an inner surface (24a) of said at least one plain bearing (24).

## Description

### Technical field

The present inventive concept relates to the field of pick and place technology.

More particularly, it relates to a mounting tool for a component mounting machine.

### Background

Machines for pick-and-place mounting of components on a workpiece, such as a Printed Circuit Board (PCB), or a substrate for a System in Package (SiP), are subject to different, often contradictory demands, such as mounting speed, mounting precision, size, price, etc. The expression "pick and place" may be understood by the person skilled in the art as describing the very mounting operation where a mounting head is moved to a component feeder area, where the mounting head picks one or more components from one or more of the component feeders, and then is moved to a mounting area where the mounting head places the component or components on the workpiece.

The electronic components may be provided by means of several component tapes wound on reels and stored in a magazine configured to be inserted into the component mounting machine.

The mount head of a pick-and-place machine may comprise several mounting tools for picking a plurality of components. As an example, the mounting tools may be arranged in a row (a piano-type mount head). A mounting tool may thus function as a nozzle for engaging with the component to be picked, and each mounting tool may be designed for picking a single component.

In component mounting machines designed for operating at high speed, the mounting tools are often spring loaded to reduce impact forces when components are picked and placed at high speed. The design of the mounting tool and the spring have a large impact on accuracy of the component mounting machine. To achieve high accuracy low clearance in spring tool design is important. Any movement other than in vertical direction will reduce the accuracy of the machine.

Thus, there is a need in the art for improved spring-loaded mounting tools for component mounting machines.

### Summary

It is an object of the invention to at least partly overcome one or more limitations of the prior art. In particular, it is an object to provide a mounting tool that facilitate pick-and-place of components with increased accuracy.

As a first aspect of the invention, there is provided a mounting tool for picking and placing a component in a component mounting machine, wherein said mounting tool comprises
a base portion arranged at an upper end of said mounting tool,
a tip holder extending from said base portion in the vertical direction and further supported in said base portion by at least one plain bearing around a vertical rotational axis (V);
a mounting tool tip attached to said tip holder at a lower end of said mounting tool and arranged for engagement with a component to be mounted, and wherein
said tip holder is spring loaded in said base portion with a coiled spring extending around the vertical rotational axis (V) and attached to said tip holder such that said tip holder may be pressed down in the vertical direction against the elastic force of said coiled spring upon engagement with a component to be mounted;
and further wherein
said tip holder is arranged with a preloading force against an inner surface of said at least one plain bearing.

The mounting tool may be arranged for engaging with a mount head of a component mounting machine. Such a mount head may be configured for receiving a plurality of mounting tools.

The upper end of the mounting tool may thus be a vertically upper portion. The base portion may be adapted for engagement with a mount head of a component mounting machine.

The tip holder may be arranged within the base portion and may extend out from the base portion. Thus, the base portion may thus have an opening through which the tip holder extends. The tip holder is further arranged for holding a mounting tool tip. The mounting tool tip may be removable from the tip holder.

The tip holder may thus be slidingly arranged within the base portion such that it may slide vertically relative the base portion against the force of the coiled spring, such as when it is being pressed with a vertical force. This may for example be when engaging a component to be picked. The coiled spring may be arranged around the tip holder within the base portion. Further, the spring-loaded tip holder may reduce impact forces when components are picked and placed at high speed.

The tip holder is further arranged with a preloading force against an inner surface of the at least one plain bearing. This force preloading force may be such that little or zero clearance is achieved in both uncompressed and compressed position of the tip holder and in both radial and rotational direction.

The preloading force may be such that the tip holder abuts the inner surface of the at least one plain bearing. As an example, the tip holder may form at least one, such as at least two, points of contact with the inner surface of at least one plain bearing.

The at least one plain bearing may comprise an upper and lower plain bearing.

The mounting tool tip is the part of a component mounting machine that actually engages with the components that are to be picked. It can be releasbly mounted to a mounting tool of a component mounting machine and may thus function as a spare part to the mounting tool. The mounting tool itself is rotatably mounted in a component mounting machine and the mounting tool tip, when mounted to the mounting tool, is thus also rotatably mounted in the component mounting machine.

The first aspect of the invention is based on the insight that having the base portion arranged with a preloading force against an inner surface of said at least one plain bearing, little or zero clearance may be achieved and at the same time keep the friction within a tolerable level. When traditionally designing a spring tool using sliding bearings, tolerances is set to get low clearance and achieve good enough accuracy. Zero clearance is however not possible just by changing tolerances of parts, with zero clearance in sliding bushings spring motion of tool will jam and friction will be too high. Thus, the mounting tool of the first aspect uses a small preload force in a sliding bushing that may achieve zero clearance in both uncompressed and compressed position and in both radial and rotational direction. Such a preload force may be easy adjusted to be larger than all acceleration forces on the spring-loaded moving parts of the mounting tool.

In embodiments of the first aspect, the tip holder is arranged with a preloading force that is larger than the acceleration forces on the tip holder.

As an example, the tip holder may have a weight between 2 to 4 g, and the preloading force may be between 0.3 - 2.0 N. As an example, the preloading force may be between 0.8 and 1.2 N, such as about 1.0 N. The friction coefficient between tip holder and plain bearing may be about 0.1

In embodiments of the first aspect, the coiled spring is prerotated in said base portion such that said tip holder is arranged with a preloading force against an inner surface of said at least one plain bearing.

Thus, preload may be realized by prerotation of the coiled spring, i.e. the same spring that is used to achieve the required compression force of the mounting tool.

As an example, the tip holder may comprise a flange portion extending around rotational axis (V) in a horizontal plane, said flange portion comprising at least one recess arranged on a horizontal surface, wherein the at least one recess is adapted for receiving an end portion of said spring, thereby allowing adjustment of the amount of prerotation of said coiled spring.

The at least one recess may be a plurality of recesses. Such recesses may beholes or through holes in the flange portion, and may allow for adjustment of the pre-rotation of the spring and thus the amount of preloading force.

In embodiments of the first aspect, the coiled spring is arranged in said base portion with a compression force in the vertical direction.

Thus, the coiled spring may be arranged with a compression force in the vertical direction at rest, i.e. also when the mounting tool is not in engagement with any component.

The at least one plain bearing may comprise an upper and lower plain bearing.

In embodiments of the first aspect, the least one plain bearing comprises an upper and lower bushing arranged around said vertical rotational axis (V).

In embodiments of the first aspect tip holder comprises a shaft portion extending in the vertical direction in said base portion.

Hence, the tip holder may comprise a shaft portion extending in the vertical direction and this shaft portion may be supported in said base portion by the upper and lower plain bearings. The bearing or bearings may be arranged for allowing a vertical movement of the tip holder within the base portion.

As a further example, the tip holder may comprise a pin extending from an outer surface of said shaft portion, and said pin may be arranged for sliding engagement with a vertically extending groove on an inner surface of said base portion.

Such a tip may thus slide in the groove upon compression of the spring, such as upon engagement of the tip portion with a component to be mounted. Thus, the pin may be arranged to move freely within the groove in the vertical direction.

Furthermore, the tip holder may be arranged in said base portion such that said pin is pressed against an inner surface of said vertically extending groove due to said preloading force.

If the tip holder is preloaded due to prerotation of the coiled spring, the pin may be off-center in said groove. Therefore, also a radial preloading force may be applied on the at least one plain bearing, such as on an upper and lower bushing.

As discussed above, the at least one plain bearing may comprise an upper and lower plain bearing, such as an upper and lower bushing. The pin may then be arranged vertically between the upper and lower bushing.

As an example, the pin may be arranged at a vertical position that is in the middle between the upper and lower bushing. This may give a high stability since the force against the inner surface of the plain bearings may be divided substantially equally between the upper and lower bushings.

The at least one plain bearing, such as a bushing, may have a circular inner surface, i.e. have a uniform radius as seen in a horizontal cross-section through the bearing. Further, the vertical shaft portion of the mounting tool may have a uniform shaft radius. Thus, due to the preloading force, the tip holder, such as a tip holder in the form of a vertical shaft with a circular cross-section, may be pressed against the inner surface of the plain bearing to form a single point of contact against the inner surface of the bearing.

However, in embodiments of the first aspect, the shaft portion has a non-uniform shaft radius (R) such that said tip holder forms at least two points of contact (P1, P2) against an inner surface of the plain bearing. The shaft portion may have a non-uniform radius as seen in a horizontal plane.

Thus, shaft portion may have a larger radius in one direction, e.g. as seen in a horizontal plane through at least one plain bearing, which makes the outer surface of the shaft portion non-uniform. Due to this, the tip holder may due to the preloading force form at least two points of contact with the inner surface of the bearing. This is advantageous in that it increases the stability of the tip holder within the base portion.

As an example, the non-uniform inner radius (R) may be largest in a direction D, as seen in a horizontal plane through said plain bearing, thereby forming two points of contact (P1, P2) between said tip holder and said inner surface such that the inner bearing surface in direction D is arranged between said two points of contact (P1, P2).

As a second aspect of the invention, there is provided a mount head for picking and placing a plurality of components in a component mounting machine, the mount head comprising at least one mounting tool according to the first aspect above.

This aspect may generally present the same or corresponding advantages as the former aspect. Effects and features of this second aspect are largely analogous to those described above in connection with the first aspect. Embodiments mentioned in relation to the first aspect are largely compatible with the second aspect.

The mount head may be a mount head of "piano" type, i.e. a mount head comprising a plurality of mounting tools arranged in a row. At least two of the mounting tools, such as all of the mounting tools, may be mounting tools as of the second aspect discussed herein above.

The mount head may thus be adapted to receive at least two mounting tools arranged along a horizontal axis H.

The mount head may thus be arranged to be moved in a horizontal direction during operation, i.e. when arranged in a component mounting machine.

As a third aspect of the invention, there is provided a component mounting machine comprising at least one mounting tool the first aspect discussed herein above.

This aspect may generally present the same or corresponding advantages as the former aspects. Effects and features of this third aspect are largely analogous to those described above in connection with the first and second aspects. Embodiments mentioned in relation to the first and second aspects are largely compatible with the third aspect.

As an example, the component mounting machine may comprising a mount head according to the second aspect above.

The component mounting machine may be a pick and place (PnP) machine, such as a PnP machine for mounting electronic components on a Printed Circuit Board (PCB). Thus, the components may be electronic components. The electronic components include for example resistors, capacitors and transistors.

The component mounting machine may be configured for receiving a plurality of tape reels onto which the components to be mounted are stored. The component mounting machine may thus comprise a machine frame arranged for receiving a source of electronic components, such as electronic components mounted in tape reels and magazines. These may for example be arranged within a feeder area of the machine frame.

The component mounting machine may comprise a control unit configured for controlling the rotation of the mounting tools of the mount head around their around individual vertical rotational axes (V). The control unit may also be configured for positioning the mounting tools at the right coordinates in the horizontal plane.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a is a schematic illustration of a mounting tool.
Fig. 1b is a schematic illustration of a tip holder of a mounting tool.
Fig. 2 is a further illustration of two mounting tool attached to a mount head of a component mounting machine.
Fig. 3 illustrates how different forces are distributed in the preloaded tip holder.
Fig. 4 illustrates how the different forces are distributed when using a plain bearing having an irregular inner radius.

### Detailed description

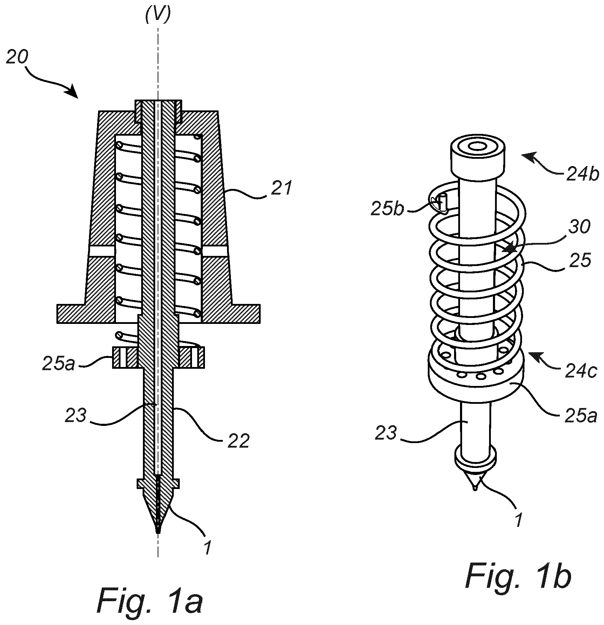

Fig. 1a is a side section view of a mounting tool 20 for picking and placing a component in a component mounting machine. The mounting tool 20 may be rotatably arranged in a component mounting machine around a vertical rotational axis (V).

The mounting tool 20 comprises a base portion 21 that is arranged at an upper end, i.e. a vertically upper end, of the mounting tool 20. The base portion has in this example a frustoconical shape with the base arranged at the vertically lower portion.

The mounting tool 20 further comprises a tip holder 22 extending from the base portion 21 in the vertical direction. The tip holder 22 is in this example in the form of a vertical shaft extending in the vertical direction and having a circular cross-section. Moreover, the tip holder 22 is supported in the base portion 21 by at least one plain bearing 24 around the vertical rotational axis (V). As also illustrated in Fig. 1b, the tip holder is supported by an upper 24b and lower 24c plain bearing.

At the lowermost end of the tip holder 22, there is a mounting tool tip 1 attached. This tip functions as a nozzle and is arranged for engagement with a component to be mounted. The size and shape of the tip may depend on the specific components to be picked, i.e. depend on the size and shape of the components to be picked.

Furthermore, the tip holder 22 is spring loaded in the base portion 21 with a coiled spring 25, which extends around the vertical rotational axis (V). The coiled spring 25 is attached to the tip holder 22 and such that it may be pressed down in the vertical direction against the elastic force of the coiled spring 25. This may for example be during upon engagement with a component to be mounted. The tip holder 22 is thus also slidingly arranged within the base portion, i.e. it may slide in the vertical direction within the base portion 21 when the coiled spring is being compressed.

In Figure 1b, the base portion 21 has been removed from the tip holder 22 in the mounting tool discussed in relation to Fig. 1a above. The tip holder 22 is arranged with a preloading force against an inner surface 24a of the two plain bearings 24b and 24c, that are arranged around said vertical rotational axis (V). The preloading force is realized by prerotating the coiled spring 25, i.e. using the same coiled spring that is used to achieve the required compression force of the mounting tool 20. Hence, the coiled spring 25 is prerotated in said base portion 21 around vertical rotational axis V such that the tip holder 22 is arranged with a preloading force against an inner surface 24a of the two plain bearings 24b and 24c. Prerotation of the coiled spring may be achieved by two hook portions 25a, 25b, that form the end portion of the coiled spring. These hook portions 25a and 25b may extend in the vertical direction and may be arranged for being inserted into receiving means of the base portion 21.

In this embodiment, the coiled spring 25 is also arranged in the base portion 21 with a compression force in the vertical direction.

With design of the mounting tool as shown in Figs. 1a and 1b, mounting tool compression will be possible with minimum of friction forces and still zero clearance during operation of a component mounting machine. The tip holder may be arranged with a preloading force that is larger than the acceleration forces experienced by the tip holder 22. Thus, the preload force may be adjusted to be larger than all acceleration forces on tip holder mass including component mass.

Typical values for weight of tip holder including a component to be picked may be around 3 grams. The acceleration in vertical and horizontal direction may be around 30 m/s2 and the coefficient of friction is assumed to be 0.1. Then, the preloading force may need to be above 90 mN, and the spring force in a of the coiled spring 25 may thus be set be from 0.10 N, such as from 0.25 N and higher.

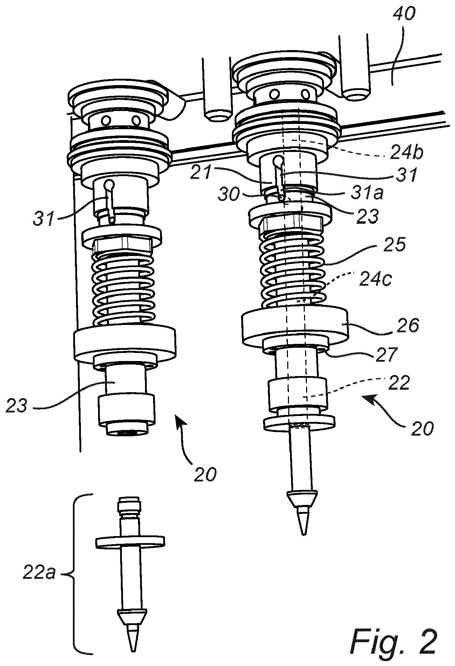

Figure 2 shows two mounting tools 20 in which the outer portions of the base portions 21 have been removed for clarity. The mounting tools 20 are attached to a mount head 40 of a component mounting machine (only a portion of the mount head is illustrated in Fig. 2). As an example, the base portions 21 may be integrated in the mount head 40. As illustrated in Fig. 2, the tip holder 22 comprises a flange portion 26 that extends around rotational axis (V) in a horizontal plane. This flange portion 26 comprises a plurality of holes 27 arranged on a horizontal surface of the flange portion. These holes 27 are adapted for receiving an end portion 25 of the spring 25, such as receiving the hook portion 25a of the coiled spring 25. Due to the distribution of the holes 27 on flange 26, they can be used to fix the coiled spring 25 in a prerotated state, and by manually rotating and inserting the hook portion in a different hole 27, the amount of prerotation, and thus preloading force, may be adjusted.

As illustrated in Fig. 2, the tip holder 22 is arranged within base portion 21 and supported by upper 24b and lower 24c bushings. The tip holder 22 comprises a pin 30 extending from an outer surface 23a of the vertical shaft portion 23 of the tip holder 22. This pin 30 is in sliding engagement with a vertically extending groove 31 on an inner surface of the base portion 21. Thus, upon vertical movement of the tip holder 22 within the base portion 21, the pin 30 may slide within the groove 31. The dimensions of the groove 31 may thus limit the vertical movement of the pin 30. Due to the pin 30 being offcenter in the groove 31, there is also a radial preloading force acting on the tip holder as the pin is pressed against an inner surface of the groove 31.

The pin 30 and the groove 31 is in this embodiment arranged vertically above the coiled spring 25.

Due to the preloading force applied to the tip holder 21, the pin 31 is pressed against the inner surface 31a of the vertically extending groove 31. Thus, the movement of the pin 30 is not restricted within the groove 31 in the vertical direction, but it may due to the preloading force always be in contact with the inner surface 31 of the groove 31 due to the torque of the spring 25. Due to the torque from the coiled spring 25, the pin is always in contact with one side, or one inner surface, of the groove 31.

As further illustrated in Fig. 2, the vertically lowermost portion of the tip holder 22 may in embodiments be a releasable portion 22a that is releasably mounted to the rest of the tip holder 22, such as to the vertically extending shaft 23. The mounting tool tip 1 is in turn be attached to the releasable portion 22a, which thus makes it easy to engage and disengage the releasable portion of the tip holder..

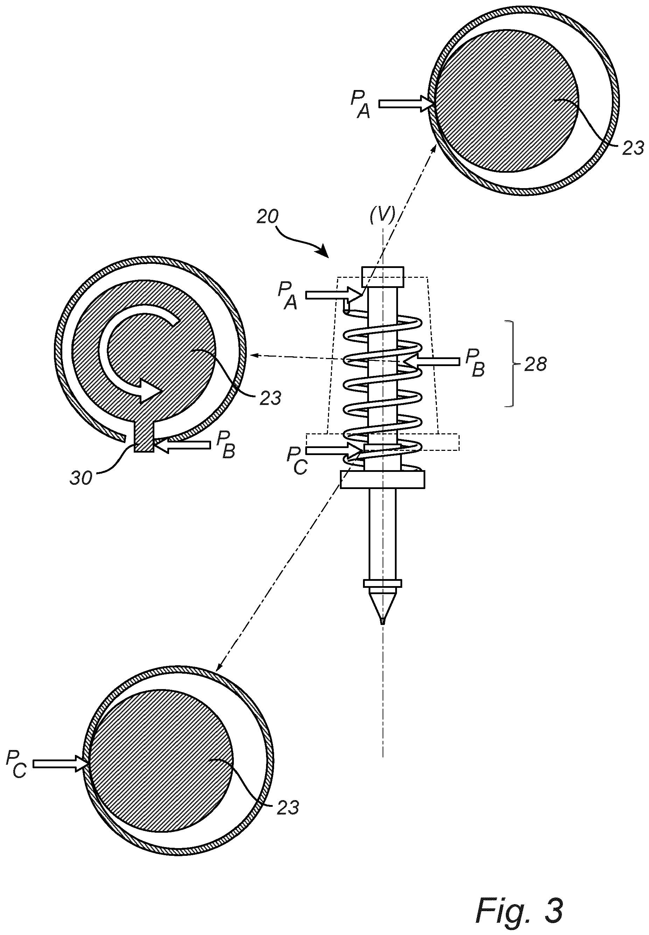

Fig. 3 schematically illustrates the different forces acting on the tip holder 22 of the mounting tool 20 due to the preloading force. In this embodiment, the tip holder 21 comprises a pin 30, as discussed in relation to Fig. 2 above, that is in sliding engagement with a groove 30 of the mounting tool. Furthermore, the pin 30 is arranged vertically between the upper 24b and lower 24c bushing. The torque direction from prerotation of the coiled spring 25 is illustrated by the curved arrows in the right-hand figures of Fig. 3.

As illustrated in Fig. 3, a force P_{A} is acting on the tip holder 22 in a first direction due to the contact with the inner surface of the upper bushing 24b. Further, a force Pc is acting in the first direction due to the contact with the inner surface of the lower bushing 24c. Within the groove 31, the torque of the prerotated spring causes a force P_{B} to act on the tip holder 21 in a second direction, which is opposite to the first direction. Due to the prerotation of the spring 25, the bushings 24b and 24c are stable.

The plain bearings of the mounting tool 20 as illustrated in Fig. 3 have a circular cross section. This has the effect that a single point of contact is formed between vertical shaft and the inner surface of the plain bearings if the vertical shaft has a uniform shaft radius.

Further, the shaft portion 23 may be arranged in the base portion 21 such that there is an axial portion 28 along vertical axis V in which the shaft portion 23 is not in contact with the inner surface of the base portion. This axial portion 28 may be arranged vertically between the two plain bearings. As an example, the shaft 23 may have a smaller radius at the axial portion 28. As an alternative, the inner surface of the base portion 21 may be larger at the axial portion 28.

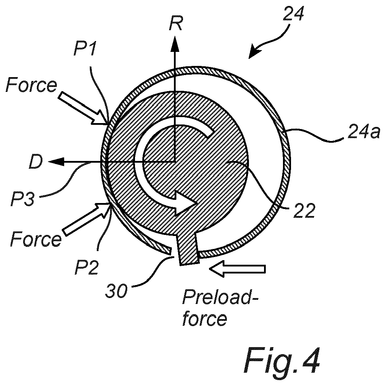

Fig. 4 illustrates an embodiment of a mounting tool 20 in which the shaft portion 23 has a non-uniform shaft radius R. Thus, at each plain bearing, the tip holder 21 form two points of contact P1, P2 with the inner surface. In the tip holder as illustrated in Fig. 4, the shaft radius is larger in direction D, such that instead of a single point of contact, two points of contact P1 and P2 are formed. These are thus located on either side of an imaginary point P3 on the inner surface in direction D, as seen along the inner circumference of the plain bearing. There are thus two forces at P1 and P2 counteracting the preloading force from the torque of the spring.

The imaginary point P3 is thus the point on the inner surface where the inner radius has its largest value. Fig. 4 thus illustrates an embodiment in which the inner surface of the plain bearing has a non-uniform inner radius R that is largest in a direction D, as seen in a horizontal plane through said plain bearing 24. Thereby, two points of contact P1, P2 are between the tip holder 22 and the inner surface 24a such that the inner bearing surface in direction D is arranged between said two points of contact (P1, P2). This gives the design even further stability.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A mounting tool (20) for picking and placing a component in a component mounting machine (60), wherein said mounting tool (20) comprises
a base portion (21) arranged at an upper end of said mounting tool,
a tip holder (22) extending from said base portion (21) in the vertical direction and further supported in said base portion (21) by at least one plain bearing (24) around a vertical rotational axis (V);
a mounting tool tip (1) attached to said tip holder (22) at a lower end of said mounting tool (20) and arranged for engagement with a component to be mounted, and wherein
said tip holder (22) is spring loaded in said base portion (21) with a coiled spring (25) extending around the vertical rotational axis (V) and attached to said tip holder (22) such that said tip holder (22) may be pressed down in the vertical direction against the elastic force of said coiled spring (25) upon engagement with a component to be mounted;
and further wherein
said tip holder (22) is arranged with a preloading force against an inner surface (24a) of said at least one plain bearing (24).

2. A mounting tool (20) according to claim 1, wherein said tip holder (22) is arranged with a preloading force that is larger than the acceleration forces on the tip holder (22).

3. A mounting tool (20) according to claim 1 or 2, wherein said coiled spring (25) is prerotated in said base portion (21) such that said tip holder (22) is arranged with a preloading force against an inner surface (24a) of said at least one plain bearing (24).

4. A mounting tool (20) according to claim 3, wherein said tip holder (22) comprises a flange portion (26) extending around rotational axis (V) in a horizontal plane, said flange portion (26) comprising a at least one recess (27) arranged on a horizontal surface, wherein the at least one recess (27) is adapted for receiving an end portion (25a) of said spring (25), thereby allowing adjustment of the amount of prerotation of said coiled spring (25).

5. A mounting tool (20) according to any previous claim, wherein said coiled spring (25) is arranged in said base portion (21) with a compression force in the vertical direction.

6. A mounting tool (20) according to any previous claim, wherein said at least one plain bearing (24) comprises an upper (24b) and lower (24c) bushing arranged around said vertical rotational axis (V).

7. A mounting tool (20) according to any previous claim, wherein the tip holder (20) comprises a shaft portion (23) extending in the vertical direction in said base portion (21).

8. Amounting tool (20) according to claim 7, wherein said tip holder (20) comprises a pin (30) extending from an outer surface (23a) of said shaft portion (23), and wherein said pin (30) is arranged for sliding engagement with a vertically extending groove (31) on an inner surface of said base portion (21).

9. A mounting tool (20) according to claim 8, wherein the tip holder (22) is arranged in said base portion (21) such that said pin (30) is pressed against an inner surface (31a) of said vertically extending groove (31) due to said preloading force.

10. A mounting tool (20) according to claim 6 and claim 8 or 9, wherein said pin (30) is arranged vertically between the upper (24b) and lower (24c) bushing.

11. A mounting tool (20) according to any one of claims 7-10, wherein the shaft portion (23) has a non-uniform shaft radius (R) such that said tip holder forms at least two points of contact (P1, P2) against an inner surface (24a) of the plain bearing (24)

12. A mounting tool (20) according to claim 11, wherein the non-uniform shaft radius (R) is largest in a direction D, as seen in a horizontal plane through said plain bearing (24), thereby forming two points of contact (P1, P2) between said tip holder (22) and said inner surface (24a) such that the inner bearing surface in direction D is arranged between said two points of contact (P1, P2).

13. A component mounting machine (60) comprising at least one mounting tool according to any one of claims 1-12.
